# FASCICULE DE BREVET EUROPEEN

(11) **EP 3 646 682 B1**
(45) Date de publication et mention de la délivrance du brevet: **16.07.2025**
(21) Numéro de dépôt: 18730842.4
(22) Date de dépôt: 29.05.2018
(51) Int. Cl.: H05K 7/14

(54) **ASSEMBLAGE DE PIÈCES ET PROCÉDÉ DE FABRICATION D'UN TEL ASSEMBLAGE**
ANORDNUNG VON TEILEN UND VERFAHREN ZUR HERSTELLUNG SOLCH EINER ANORDNUNG
ASSEMBLY OF PARTS AND METHOD OF PRODUCING ONE SUCH ASSEMBLY

(30) Priorité: 28.06.2017 FR 1755944
(43) Date de publication de la demande: 06.05.2020
(73) Titulaire: Valeo Electrification, 95800 Cergy (FR)
(72) Inventeur: FALGUIER, Manuel, 94046 Créteil cedex (FR); HENNEGUET, Romain, 94046 Créteil cedex (FR); MERCIER, Philippe, 94046 Créteil cedex (FR)
(74) Mandataire: Valeo Powertrain Systems
(86) Numéro de dépôt international: PCT/FR2018/051242
(87) Numéro de publication internationale: WO 2019/002708

(56) Documents cités:
- EP-A1- 1 361 370
- EP-A1- 1 886 396
- EP-A1- 1 886 396
- WO-A1-2015/170037
- WO-A1-2015/170037
- US-A- 5 251 370
- US-A- 6 078 155
- US-A- 6 078 155
- US-A1- 2012 216 390
- US-A1- 2017 163 130
- US-A1- 2017 163 130

## Description

### DOMAINE TECHNIQUE

La présente invention concerne un assemblage de pièces et un procédé de fabrication d'un tel assemblage.

### ARRIÈRE-PLAN TECHNOLOGIQUE

Les documents US 2012/216390, EP 1 361 370 et US 5 251 370 connus de l'art antérieur décrivent des assemblages de pièces. La demande internationale PCT publiée sous le numéro WO 2006 129 031 A1 décrit un assemblage de pièces du type comportant :
- une première pièce munie d'un conduit vertical présentant une partie inférieure et une partie supérieure,
- une deuxième pièce reposant sur une face supérieure de la première pièce et munie d'un trou recevant la partie supérieure du conduit.

Dans la demande internationale PCT précédente, cet assemblage fait partie d'un convertisseur de tension destiné à être connecté à une machine électrique, et à être fixé à une troisième pièce, en l'occurrence un plateau supérieur de cette machine électrique. Pour cela, la partie supérieure du conduit est rabattue par rivetage contre la deuxième pièce, et un goujon est introduit dans le conduit et vissé au plateau supérieur de la machine électrique. Ainsi, le convertisseur de tension est coincé entre la machine électrique et la tête du goujon qui appuie sur la partie supérieure rivetée du conduit.

Le système de fixation précédent présente comme avantage d'être très compact puisque la fixation des première et deuxième pièces s'effectue au même endroit que la fixation à la troisième pièce.

L'invention a pour but de proposer un assemblage de pièces plus fiable.

### RÉSUMÉ DE L'INVENTION

À cet effet, il est proposé un assemblage de pièces du type précité, caractérisé en ce que la deuxième pièce présente, dans le trou, un épaulement contre lequel la partie supérieure du conduit est rabattue de manière à enserrer la deuxième pièce entre la partie supérieure rabattue du conduit et la face supérieure pour fixer la deuxième pièce à la première pièce.

Ainsi, l'assemblage de pièce est plus fiable car la partie supérieure reste à l'intérieur du trou, de sorte qu'il est possible de fixer l'assemblage au moyen d'une tige introduite dans le trou de la deuxième pièce et dans le conduit de la première pièce et présentant une extrémité supérieure munie d'une butée reposant sur une face supérieure de la deuxième pièce, et non sur la partie supérieure rabattue du conduit puisqu'elle se trouve dans le trou, sous la butée.

L'assemblage de pièce comporte en outre :
- une troisième pièce présentant un trou situé au-dessous et dans la continuité du conduit,
- une tige de fixation s'étendant successivement dans le trou de la deuxième pièce, dans le conduit de la première pièce et dans le trou de la troisième pièce, la tige de fixation présentant une extrémité supérieure munie d'une butée reposant sur une face supérieure de la deuxième pièce.

De façon optionnelle, le conduit est en métal.

De façon optionnelle également, la première pièce est d'un seul bloc avec le conduit.

De façon optionnelle également, la première pièce et la deuxième pièce font partie d'un convertisseur de tension, la première pièce étant un dissipateur de chaleur destiné à dissiper la chaleur de composants de puissance du convertisseur de tension et la deuxième pièce étant un boîtier destiné à recevoir une carte électronique de commande des composants de puissance.

De façon optionnelle également, la troisième pièce fait partie d'une machine électrique connectée au convertisseur de tension.

Il est également proposé un procédé de fabrication d'un assemblage de pièces selon l'invention, comportant :
- l'obtention de la première pièce,
- l'obtention de la deuxième pièce,
- le positionnement de la deuxième pièce de sorte que le trou de la deuxième pièce soit situé au-dessus et dans la continuité du conduit et reçoive la ou les saillies,
- le rivetage de la ou des saillies contre l'épaulement du trou de la deuxième pièce pour fixer la deuxième pièce à la première pièce.
- l'obtention d'une troisième pièce présentant un trou,
- le positionnement de l'assemblage première et deuxième pièces de sorte que le trou de la troisième pièce soit situé en-dessous et dans la continuité du conduit,
- la fixation de la troisième pièce à l'assemblage des première et deuxième pièces au moyen d'-une tige de fixation s'étendant successivement dans le trou de la deuxième pièce, dans le conduit de la première pièce et dans le trou de la troisième pièce, la tige de fixation présentant une extrémité supérieure munie d'une butée reposant sur une face supérieure de la deuxième pièce.

### DESCRIPTION DES FIGURES

La figure 1 est un schéma électrique d'un système électrique comportant un convertisseur de tension mettant en œuvre l'invention.
La figure 2 est une vue en trois dimensions de modules de puissance et d'un dissipateur de chaleur du convertisseur de tension de la figure 1.
La figure 3 est une vue en trois dimensions des éléments de la figure 2, complétés d'une carte électronique de commande et d'un boîtier de réception de la carte électronique.
La figure 4 est une coupe en trois dimensions montrant un système de fixation du dissipateur de chaleur et du boîtier.
La figure 5 est en vue en coupe du système de fixation de la figure 4.
La figure 6 est une vue similaire à la figure 5, illustrant en outre la fixation du convertisseur de tension sur une machine électrique.
La figure 7 est un schéma-blocs illustrant les étapes successives d'un procédé selon l'invention d'assemblage de pièces.

### DESCRIPTION DÉTAILLÉE

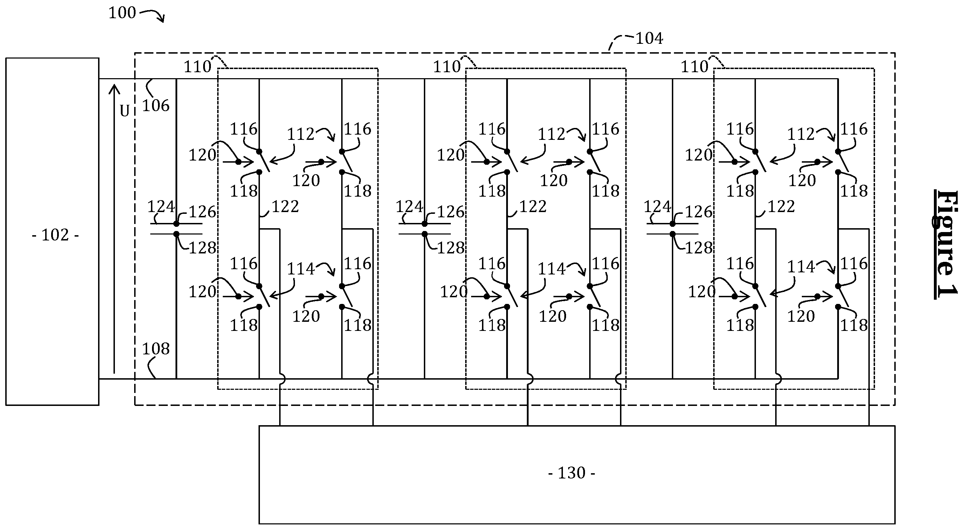

En référence à la figure 1, un système électrique 100 mettant en œuvre l'invention va à présent être décrit.

Le système électrique 100 est par exemple destiné à être implanté dans un véhicule automobile.

Le système électrique 100 comporte tout d'abord une source d'alimentation électrique 102 conçue pour délivrer une tension continue U, par exemple comprise entre 20 V et 100 V, par exemple 48 V. La source d'alimentation électrique 102 comporte par exemple une batterie.

Le système électrique 100 comporte en outre une machine électrique 130 comportant plusieurs phases (non représentées) destinées à présenter des tensions de phase respectives.

Le système électrique 100 comporte en outre un convertisseur de tension 104 connecté entre la source d'alimentation électrique 102 et la machine électrique 130 pour effectuer une conversion entre la tension continue U et les tensions de phase.

Le convertisseur de tension 104 comporte tout d'abord une barre omnibus positive 106 et une barre omnibus négative 108 destinées à être connectées à la source d'alimentation électrique 102 pour recevoir la tension continue U, la barre omnibus positive 106 recevant un potentiel électrique haut et la barre omnibus négative 108 recevant un potentiel électrique bas.

Le convertisseur de tension 104 comporte en outre au moins un module de puissance 110 comportant une ou plusieurs barres omnibus de phase 122 destinées être respectivement connectées à une ou plusieurs phases de la machine électrique 130, pour fournir leurs tensions de phase respectives.

Dans l'exemple décrit, le convertisseur de tension 104 comporte trois modules de puissance 110 comportant chacun deux barres omnibus de phase 122 connectées à deux phases de la machine électrique 130.

Plus précisément, dans l'exemple décrit, la machine électrique 130 comporte deux systèmes triphasés comportant chacun trois phases, et destinés à être électriquement déphasés de 120° l'un par rapport à l'autre. De préférence, les premières barres omnibus de phase 122 des modules de puissance 110 sont respectivement connectées aux trois phases du premier système triphasé, tandis que les deuxièmes barres omnibus de phase 122 des modules de puissance 110 sont respectivement connectées aux trois phases du deuxième système triphasé.

Chaque module de puissance 110 comporte, pour chaque barre omnibus de phase 122, un interrupteur de côté haut 112 connecté entre la barre omnibus positive 106 et la barre omnibus de phase 122 et un interrupteur de côté bas 114 connecté entre la barre omnibus de phase 122 et la barre omnibus négative 108. Ainsi, les interrupteurs 112, 114 sont agencés de manière à former un bras de hachage, dans lequel la barre omnibus de phase 122 forme un point milieu.

Chaque interrupteur 112, 114 comporte des première et deuxième bornes principales 116, 118 et une borne de commande 120 destinée à sélectivement ouvrir et fermer l'interrupteur 112, 114 entre ses deux bornes principales 116, 118 en fonction d'un signal de commande qui lui est appliqué. Les interrupteurs 112, 114 sont de préférence des transistors, par exemple des transistors à effet de champ à structure métal-oxyde-semiconducteur (de l'anglais « Metal Oxide Semiconductor Field Effect Transistor » ou MOSFET) présentant une grille formant la borne de commande 120, et un drain et une source formant respectivement les bornes principales 116, 118.

Dans l'exemple décrit, les interrupteurs 112, 114 ont chacun la forme d'une plaque, par exemple sensiblement rectangulaire, présentant une face supérieure et une face inférieure. La première borne principale 116 s'étend sur la face inférieure, tandis que la deuxième borne principale 118 s'étend sur la face supérieure. En outre, la face inférieure forme une face de dissipation de chaleur.

Le convertisseur de tension 104 comporte en outre, pour chaque module de puissance 110, un condensateur 124 présentant une borne positive 126 et une borne négative 128 respectivement connectées à la barre omnibus positive 106 et à la barre omnibus négative 108.

Il sera apprécié que la barre omnibus positive 106, la barre omnibus négative 108 et les barres omnibus de phase 122 sont des éléments rigides conçus pour supporter des courants électriques d'au moins 1 A. Elles présentent de préférence une épaisseur d'au moins 1 mm.

En outre, dans l'exemple décrit, la machine électrique 130 a à la fois une fonction d'alternateur et de moteur électrique. Plus précisément, le véhicule automobile comporte en outre un moteur thermique (non représenté) présentant un axe de sortie auquel la machine électrique 130 est reliée par une courroie (non représentée). Le moteur thermique est destiné à entraîner des roues du véhicule automobile par l'intermédiaire de son axe de sortie. Ainsi, en fonctionnement comme alternateur, la machine électrique fournit de l'énergie électrique en direction de la source d'alimentation électrique 102 à partir de la rotation de l'axe de sortie. Le convertisseur de tension 104 fonctionne alors comme redresseur. En fonctionnement comme moteur électrique, la machine électrique entraîne l'arbre de sortie (en complément ou bien à la place du moteur thermique). Le convertisseur de tension 104 fonctionne alors comme onduleur.

La machine électrique 130 est par exemple localisée dans une boîte de vitesses ou bien dans un embrayage du véhicule automobile ou bien en lieu et place de l'alternateur.

Dans la suite de la description, la structure et la disposition d'éléments du convertisseur de tension 104 et de la machine électrique 130 vont être décrits plus en détail, en référence à une direction verticale H-B, « H » représentant le haut et « B » représentant le bas.

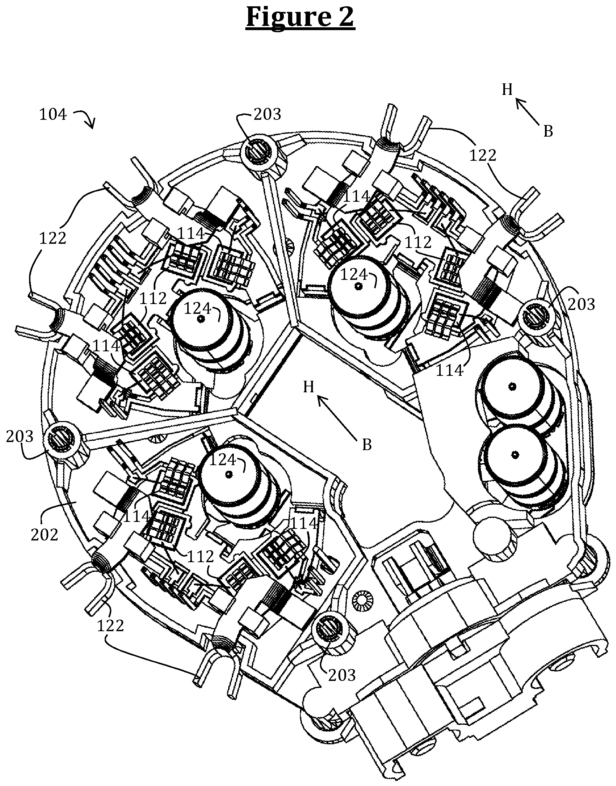

En référence à la figure 2, le convertisseur de tension 104 comporte un dissipateur de chaleur 202 destiné à dissiper la chaleur des interrupteurs 112, 114. Le dissipateur de chaleur 202 est de préférence en métal et formé d'un seul bloc. Le dissipateur de chaleur 202 comporte au moins un conduit 203 vertical de fixation à la machine électrique 130, délimitant un trou de passage de tige, comme cela sera expliqué par la suite.

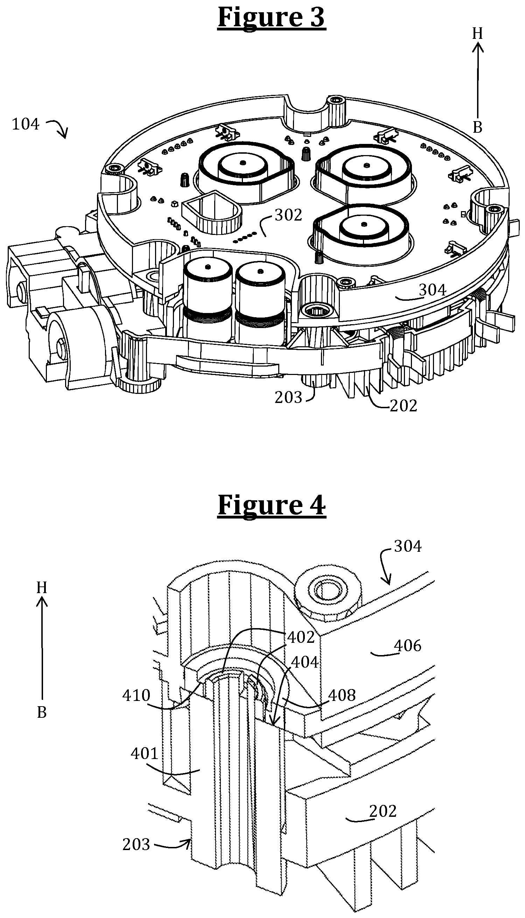

En référence à la figure 3, le convertisseur de tension 104 comporte en outre un module de commande 302, 304 destiné à commander les interrupteurs 112, 114, comportant une carte électronique 302 et un boîtier 304 de réception de la carte électronique 302.

En référence à la figure 4, chaque conduit 203 comporte une partie inférieure 401 et une partie supérieure 402 s'élevant, dans l'exemple décrit, depuis une face supérieure 404 de la partie inférieure 401. Dans l'exemple décrit, la partie supérieure 402 comporte plusieurs saillies ayant chacune la forme d'un muret s'étendant circonférentiellement autour du trou délimité par le conduit 203.

Le boîtier 304 comporte un corps principal 406 et des inserts creux 408 fixés au corps principal 406. Plus précisément, le corps principal 406 présente des ouvertures dans lesquelles les inserts creux 408 sont respectivement insérés de manière solidaire du corps principal 406. Les inserts creux 408 sont par exemple en métal, par exemple en aluminium, et le corps principal 406 du boîtier 304 est par exemple en plastique, par exemple surmoulé autour des inserts creux 408. Chaque insert creux 408 du boîtier 304 repose, dans l'exemple décrit, sur la face supérieure 404 d'un conduit 203 associé et est muni d'un trou 409 traversant situé au-dessus du conduit 203 associé, dans sa continuité, et recevant la partie supérieure 402 du conduit.

En outre, l'insert creux 408 présente, dans le trou 409, un épaulement 410 contre lequel la partie supérieure 402 du conduit 203 est destinée à être rabattues par rivetage pour fixer le boîtier 304 au dissipateur de chaleur 202, en enserrant l'épaulement 410 entre la partie supérieure 402 rabattue et la face supérieure 404 du conduit 203.

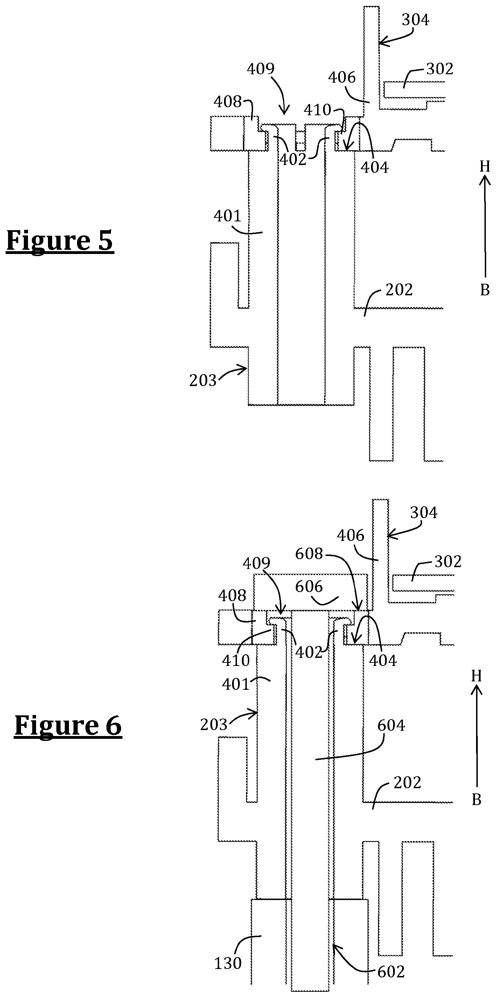

L'assemblage obtenu après rivetage de la partie supérieure 402 du conduit 203 est illustré sur la figure 5.

En référence à la figure 6, le convertisseur de tension 104 est destiné à être fixé mécaniquement à la machine électrique 130.

Pour cela, la machine électrique 130 présente des trous 602 respectivement situés en-dessous et dans la continuité de chaque conduit 203 du dissipateur de chaleur 202. Une tige 604 s'étend successivement dans le trou 409 du boîtier 304, dans le trou délimité par le conduit 203 du dissipateur de chaleur 202 et dans le trou 602 de la machine électrique 130. La tige 604 est munie d'une extrémité inférieure fixée à la machine électrique 130, par exemple vissée dans le trou 602. La tige 604 présente en outre une extrémité supérieure présentant une butée 606 reposant sur une face supérieure 608 de l'insert 408, cette face supérieure 608 étant située au-dessus de l'épaulement 410. Ainsi, le boîtier 304 et le dissipateur de chaleur 202 sont coincés entre la machine électrique 130 et la butée 606.

La butée 606 appuie sur la face supérieure 608 qui présente une surface plus dure et plus régulière que la partie supérieure 402 rabattue du conduit 203. Ainsi, la butée 606 est plus stable que si elle appuyait sur la partie supérieure 402 rabattue du conduit 203.

La tige 604 et la butée 606 sont par exemple formée par une vis, la tête de cette dernière, éventuellement complétée d'une rondelle, formant la butée 606. Alternativement, la butée 606 pourrait être formée d'un écrou vissé sur l'extrémité supérieure de la tige 604.

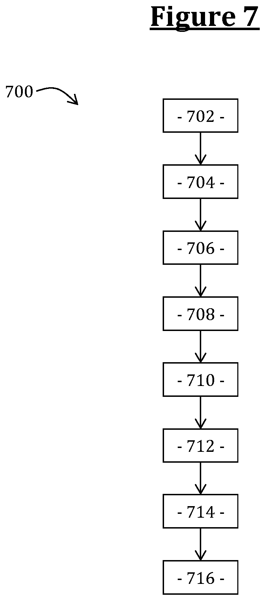

En référence à la figure 7, un procédé d'assemblage 700 de pièces va à présent être décrit.

Au cours d'une étape 702, le dissipateur de chaleur 202 est obtenu.

Au cours d'une étape 704, le boîtier 304 est obtenu.

Au cours d'une étape 706, le boîtier 304 est placé de sorte que, d'une part, le trou 409 de chaque insert creux 408 soit situé au-dessus du conduit 203 associé, dans sa continuité, et reçoive la partie supérieure 402 du conduit 203 et, d'autre part, chaque insert creux 408 repose sur la face supérieure 404 du conduit 203 associé.

Au cours d'une étape 708, la partie supérieure 402 du conduit 203 est rivetée contre l'épaulement 410 pour fixer le boîtier 304 au dissipateur de chaleur 202, comme cela est illustré sur la figure 5.

Au cours d'une étape 710, les interrupteurs 112, 114 sont connectés électriquement à la carte électronique 302. L'étape 710 peut en outre comporter d'autres opérations, comme par exemple : le résinage du boîtier PCB (acronyme de l'anglais « Printed Circuit Board », soit carte de circuit imprimé), la mise en place d'un capot, etc.

Au cours d'une étape 712, le convertisseur de tension 104 est transporté au lieu de montage sur la machine électrique 130.

Au cours d'une étape 714, la machine électrique 130 est obtenue.

Au cours d'une étape 716, le convertisseur de tension 104 est fixé sur la machine électrique 130 au moyen d'une tige s'étendant successivement dans le trou 409 du boîtier 304, dans le conduit 203 du dissipateur de chaleur 202 et dans le trou 602 de la machine électrique 130 et d'une butée située sur une extrémité supérieure de la tige et reposant sur la face supérieure 608 de l'insert 408, comme cela est illustré sur la figure 6.

La présente invention n'est pas limitée au mode de réalisation décrit précédemment, mais est au contraire définie par les revendications qui suivent. Il sera en effet apparent à l'homme du métier que des modifications peuvent y être apportées.

## Revendications

1. Assemblage de pièces comportant :
- une première pièce (202) munie d'un conduit (203) vertical présentant une partie inférieure (401) et une partie supérieure (402),
- une deuxième pièce (304) reposant sur une face supérieure (404) de la première pièce (202) et munie d'un trou (409) recevant la partie supérieure (402) du conduit (203),
une troisième pièce (130) présentant un trou (602) situé au-dessous et dans la continuité du conduit (203),
- une tige de fixation (604) de la troisième pièce (130) s'étendant successivement dans le trou (409) de la deuxième pièce (304), dans le conduit (203) de la première pièce (202) et dans le trou (602) de la troisième pièce (130), la tige de fixation (604) présentant une extrémité supérieure munie d'une butée (606) reposant sur une face supérieure (608) de la deuxième pièce (304),
et en ce que la deuxième pièce (304) présente, dans le trou (409), un épaulement (410) contre lequel la partie supérieure (402) du conduit (203) est rabattue de manière à enserrer la deuxième pièce (202) entre la partie supérieure (402) rabattue du conduit (203) et la face supérieure (404) pour fixer la deuxième pièce (304) à la première pièce (202).

2. Assemblage de pièces selon la revendication 1, dans lequel le conduit (203) est en métal.

3. Assemblage de pièces selon la revendication 1 ou 2, dans lequel la première pièce (202) est d'un seul bloc avec le conduit (203).

4. Assemblage de pièces selon l'une quelconque des revendications 1 à 3, dans lequel la première pièce (202) et la deuxième pièce (304) font partie d'un convertisseur de tension (104), la première pièce (202) étant un dissipateur de chaleur destiné à dissiper la chaleur de composants de puissance (112, 114) du convertisseur de tension (104) et la deuxième pièce (304) étant un boîtier destiné à recevoir une carte électronique (302) de commande des composants de puissance (112, 114).

5. Assemblage de pièces selon la revendication précédente dans lequel la troisième pièce (130) fait partie d'une machine électrique (130) connectée au convertisseur de tension (104).

6. Procédé de fabrication d'un assemblage de pièces selon l'une quelconque des revendications 1 à 5, comportant :
- l'obtention de la première pièce (202),
- l'obtention de la deuxième pièce (304),
- le positionnement de la deuxième pièce (304) de sorte que le trou (409) de la deuxième pièce (304) soit situé au-dessus et dans la continuité du conduit (203) et reçoive la partie supérieure (402) du conduit (203),
- le rivetage de la partie supérieure (402) du conduit (203) contre l'épaulement (410) de la deuxième pièce (304) pour fixer la deuxième pièce (304) à la première pièce (202),
- l'obtention d'une troisième pièce (130) présentant un trou (602),
- le positionnement de l'assemblage première et deuxième pièces (202, 304) de sorte que le trou (602) de la troisième pièce (130) soit situé en-dessous et dans la continuité du conduit (203),
- la fixation de la troisième pièce (130) au moyen d'une tige de fixation (604) s'étendant successivement dans le trou (409) de la deuxième pièce (304), dans le conduit (203) de la première pièce (202) et dans le trou (602) de la troisième pièce (130), la tige de fixation (604) présentant une extrémité supérieure munie d'une butée (606) reposant sur une face supérieure (608) de la deuxième pièce (304).

## Patentansprüche

1. Baugruppe aus Teilen, umfassend:
- ein erstes Teil (202) mit einem vertikalen Kanal (203), der einen unteren Teil (401) und einen oberen Teil (402) aufweist,
- einem zweiten Teil (304), das auf einer Oberseite (404) des ersten Teils (202) aufliegt und mit einer Bohrung (409) versehen ist, die den oberen Teil (402) des Kanals (203) aufnimmt,
- einem dritten Teil (130) mit einer Bohrung (602), die unterhalb und in Verlängerung des Kanals (203) angeordnet ist, und
- einen Befestigungsstift (604), der sich nacheinander in die Öffnung (409) des zweiten Teils (304), in den Kanal (203) des ersten Teils (202) und in die Öffnung (602) des dritten Teils (130) erstreckt, wobei der Befestigungsstift (604) ein oberes Ende aufweist, das mit einem Anschlag (606) versehen ist, der auf einer Oberseite (608) des zweiten Teils (304) aufliegt,
und dass das zweite Teil (304) in der Bohrung (409) eine Schulter (410) aufweist, gegen die der obere Teil (402) des Kanals (203) so umgebogen ist, dass das zweite Teil (202) zwischen dem umgebogenen oberen Teil (402) des Kanals (203) und der Oberseite (404) eingeklemmt ist, um das zweite Teil (304) am ersten Teil (202) zu befestigen.

2. Teileanordnung nach Anspruch 1, wobei der Kanal (203) aus Metall besteht.

3. Teileanordnung nach Anspruch 1 oder 2, wobei das erste Teil (202) einstückig mit dem Kanal (203) ausgebildet ist.

4. Baugruppe gemäß einem der Ansprüche 1 bis 3, wobei das erste Teil (202) und das zweite Teil (304) Teil eines Spannungswandlers (104) sind, wobei das erste Teil (202) ein Kühlkörper zum Ableiten von Wärme von Leistungskomponenten (112, 114) des Spannungswandlers (104) ist und das zweite Teil (304) ein Gehäuse zur Aufnahme einer elektronischen Steuerplatine (302) für die Leistungskomponenten (112, 114) ist.

5. Zusammenbau von Teilen gemäß dem vorherigen Anspruch, wobei das dritte Teil (130) Teil einer elektrischen Maschine (130) ist, die mit dem Spannungswandler (104) verbunden ist.

6. Verfahren zur Herstellung einer Baugruppe gemäß einem der Ansprüche 1 bis 5, umfassend:
- Bereitstellen des ersten Teils (202),
- das Erhalten des zweiten Teils (304),
- das Positionieren des zweiten Teils (304) derart, dass das Loch (409) des zweiten Teils (304) über und in der Verlängerung des Kanals (203) liegt und den oberen Teil (402) des Kanals (203) aufnimmt,
- Nieten des oberen Teils (402) des Kanals (203) an der Schulter (410) des zweiten Teils (304), um das zweite Teil (304) am ersten Teil (202) zu befestigen,
- Erhalten eines dritten Teils (130) mit einem Loch (602),
- Positionieren der Baugruppe aus dem ersten und zweiten Teil (202, 304) derart, dass das Loch (602) des dritten Teils (130) unterhalb und in Verlängerung des Kanals (203) angeordnet ist,
- Befestigen des dritten Teils (130) mittels eines Befestigungsstifts (604), der sich nacheinander in das Loch (409) des zweiten Teils (304), in den Kanal (203) des ersten Teils (202) und in das Loch (602) des dritten Teils (130) erstreckt, wobei der Befestigungsstift (604) ein oberes Ende aufweist, das mit einem Anschlag (606) versehen ist, der auf einer Oberseite (608) des zweiten Teils (304) aufliegt.

## Claims

1. Assembly of parts comprising:
- a first part (202) provided with a vertical conduit (203) having a lower part (401) and an upper part (402),
- a second part (304) resting on an upper face (404) of the first part (202) and provided with a hole (409) receiving the upper part (402) of the conduit (203),
- a third part (130) having a hole (602) located below and in line with the conduit (203), and
- a fixing rod (604) extending successively into the hole (409) of the second part (304), into the conduit (203) of the first part (202) and into the hole (602) of the third part (130), the fastening rod (604) having an upper end provided with a stop (606) resting on an upper face (608) of the second part (304),
and in that the second part (304) has, in the hole (409), a shoulder (410) against which the upper part (402) of the conduit (203) is folded down so as to clamp the second part (202) between the foldeddown upper part (402) of the conduit (203) and the upper face (404) to fix the second part (304) to the first part (202).

2. Assembly of parts according to claim 1, wherein the conduit (203) is made of metal.

3. Assembly of parts according to claim 1 or 2, wherein the first part (202) is integral with the conduit (203).

4. Assembly of parts according to any of claims 1 to 3, wherein the first part (202) and the second part (304) are part of a voltage converter (104), the first part (202) being a heat sink for dissipating heat from power components (112, 114) of the voltage converter (104) and the second part (304) being a housing for receiving an electronic control board (302) for the power components (112, 114).

5. Assembly of parts according to the previous claim, wherein the third part (130) is part of an electric machine (130) connected to the voltage converter (104).

6. Method of manufacturing an assembly of parts according to any of claims 1 to 5, comprising:
- obtaining the first part (202),
- obtaining the second part (304),
- positioning the second part (304) so that the hole (409) in the second part (304) is located above and in line with the conduit (203) and receives the upper part (402) of the conduit (203),
- riveting the upper part (402) of the conduit (203) against the shoulder (410) of the second part (304) to secure the second part (304) to the first part (202),
- obtaining a third part (130) having a hole (602),
- positioning the assembly of the first and second parts (202, 304) so that the hole (602) of the third part (130) is located below and in line with the conduit (203),
- fixing the third part (130) by means of a fixing rod (604) extending successively into the hole (409) of the second part (304), into the conduit (203) of the first part (202) and into the hole (602) of the third part (130), the fixing rod (604) having an upper end provided with a stop (606) resting on an upper face (608) of the second part (304).
